# FASCICULE DE BREVET EUROPEEN

(11) **EP 1 963 876 B1**
(45) Date de publication et mention de la délivrance du brevet: **01.02.2012**
(21) Numéro de dépôt: 06841904.3
(22) Date de dépôt: 11.12.2006
(51) Int. Cl.: G01R 33/05

(54) **NOYAU MAGNÉTIQUE MINIATURE, CAPTEUR LE COMPORTANT ET PROCÉDÉ POUR LE FABRIQUER**
MINIATUR-MAGNETKERN, SENSOR DAMIT UND VERFAHREN ZU SEINER HERSTELLUNG
MINIATURE MAGNETIC CORE, SENSOR COMPRISING IT AND METHOD FOR MANUFACTURING IT

(30) Priorité: 14.12.2005 FR 0512674
(43) Date de publication de la demande: 03.09.2008
(73) Titulaire: Commissariat à l'Énergie Atomique et aux Énergies Alternatives, 75015 Paris (FR)
(72) Inventeur: JOISTEN, Hélène, F-38000 Grenoble (FR); CUCHET, Robert, F-38930 Monestier de Percy (FR); VIALA, Bernard, F-38360 Sassenage (FR); AUDOIN, Marcel, F-38360 Noyarey (FR); HIDA, Rachid, F-38000 Grenoble (FR)
(74) Mandataire: Colombo, Michel
(86) Numéro de dépôt international: PCT/FR2006/002699
(87) Numéro de publication internationale: WO 2007/068816

(56) Documents cités:
- FR-A- 2 817 622
- FR-A- 2 848 672
- SCHOENSTEIN F ET AL: "Influence of the domain structure on the microwave permeability of soft magnetic films and multilayers" JOURNAL OF MAGNETISM AND MAGNETIC MATERIALS, ELSEVIER SCIENCE PUBLISHERS, AMSTERDAM, NL, vol. 292, avril 2005 (2005-04), pages 201-209, XP004823123 ISSN: 0304-8853

## Description

L'invention concerne la structure et la fabrication d'un noyau magnétique miniature et d'un capteur magnétique miniature conçu sur la base de ce noyau magnétique.

Les noyaux magnétiques miniatures sont utilisés pour fabriquer notamment des capteurs miniatures de champ magnétique également appelés « capteurs micro-fluxgate » (voir FR 2 817 622 A).

Ces capteurs miniatures sont destinés à mesurer des champs magnétiques (ou des variations de champs magnétiques) notamment continus ou de basse fréquence, et de l'ordre de quelques nanoTeslas actuellement. Ils sont notamment utilisés pour détecter de très faibles variations du champ magnétique terrestre.

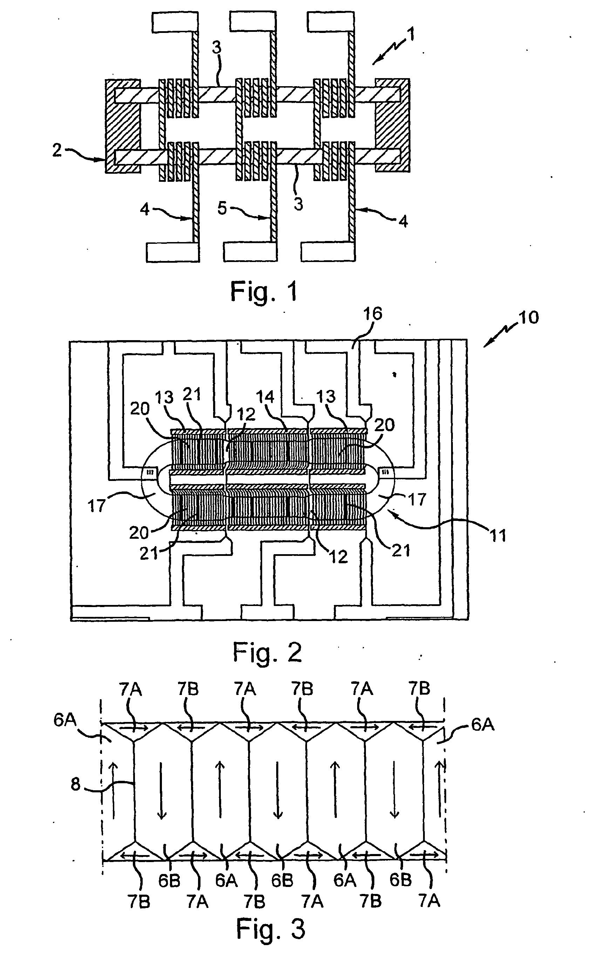

La figure 1 est un schéma de principe d'un tel capteur présentant un noyau magnétique miniature fermé comportant deux branches 3 autour desquelles sont enroulées des bobinages d'excitation 4 et un bobinage de détection 5.

Les circuits d'excitation conduisent périodiquement le noyau magnétique à saturation tandis que la bobine de détection située autour de ce noyau magnétique mesure les changements de flux magnétique au sein du noyau magnétique à travers la tension induite. En raison du comportement non linéaire de la courbe B-H des matériaux magnétiques, le flux magnétique recueilli par le bobinage de détection ne présente pas les mêmes alternances en présence ou en absence du champ magnétique à mesurer. La présence du champ magnétique à mesurer est ainsi détectable dans les harmoniques d'ordre pair (2f, 4f, ...) du signal de détection (en particulier l'harmonique d'ordre 2).

Pour améliorer la sensibilité du capteur, les enroulements du bobinage de détection 5 sont montés en différentiel afin de doubler l'amplitude des harmoniques paires du signal mesuré.

La petite taille de ces capteurs apporte une grande légèreté, peu d'encombrement et un faible coût de fabrication compte tenu de la mise en oeuvre des techniques de fabrication collective par la technologie de la microélectronique magnétique.

Cependant la miniaturisation a pour effet d'engendrer différentes instabilités, sources de bruit, empêchant en pratique de détecter des champs magnétiques plus faibles, de l'ordre du picoTesla. De tels champs sont détectables par des capteurs de plus grandes dimensions car ils ne présentent pas les instabilités propres aux capteurs miniatures.

Le signal de mesure, temporel ou fréquentiel, est ainsi très dégradé en pratique et présente un bruit pouvant atteindre des amplitudes de 100 à 1 000 nanoTeslas bien supérieures à l'amplitude que présenterait le bruit d'un tel signal en l'absence de ces instabilités (quelques nanoTeslas).

Ces instabilités également appelées « sauts d'offset» se reproduisent de façon non reproductible et non prévisible selon des périodes allant de quelques secondes à plusieurs heures, ou à basse fréquence.

Ce comportement bruité provient du noyau magnétique et son origine est expliquée ci-après à l'aide des figures 3 à 5.

Dans un matériau aux propriétés ferromagnétiques, on observe plusieurs microstructures magnétiques ou domaines magnétiques (appelés domaines de Weiss) dans lesquels les moments magnétiques (représentés par les différentes flèches sur la figure 3) sont tous orientés selon une même direction.

On peut observer sur la figure 3 que ces domaines magnétiques peuvent être modélisés selon deux types de domaines magnétiques. On distingue ainsi :
- les domaines principaux 6A, 6B au sein desquels l'aimantation est orientée selon la direction de facile aimantation du matériau magnétique dans un sens (domaines 6A) ou l'autre (domaines 6B) ; et
- les domaines dits « de fermeture » 7A, 7B qui assurent le bouclage du flux à l'intérieur du matériau magnétique, le flux rayonné à l'extérieur du matériau magnétique étant alors pratiquement nul.

Le matériau magnétique est ainsi constitué d'une pluralité de domaines magnétiques (formant ensemble des boucles magnétiques) séparés entre eux par des parois magnétiques (par exemple des « parois de Bloch »).

En pratique, les dimensions de ces domaines fluctuent notablement d'un matériau à l'autre, et dépendent également des dimensions (longueur, largeur et épaisseur), de la structure (mono ou multicouches) et de l'anisotropie du matériau magnétique.

La répartition en domaines magnétiques peut être observée notamment par « micro-effet Kerr » en envoyant une onde électromagnétique polarisée sur le matériau magnétique et en observant ensuite les différentes modifications de polarisation de l'onde réfléchie suivant le domaine sur lequel la réflexion a eu lieu.

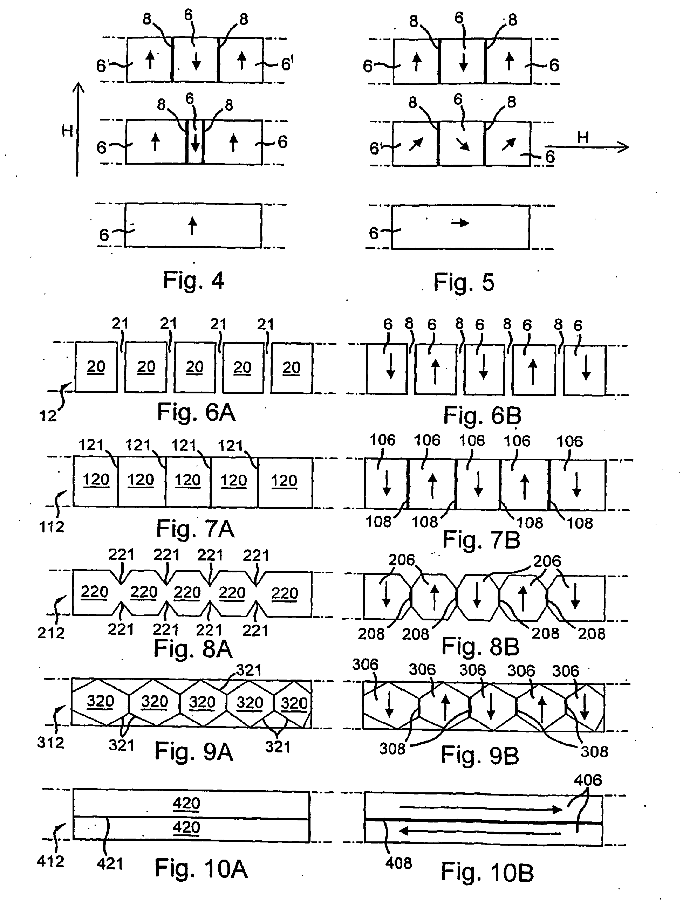

Lorsque l'on excite le matériau magnétique par un champ d'excitation H dirigé selon un premier axe privilégié du matériau magnétique (appelé axe de facile aimantation ou encore axe facile), comme illustré en figure 4, les domaines magnétiques pour lesquels l'orientation de l'excitation est la plus favorable sont privilégiés et se développent au détriment de ceux dont l'orientation est opposée. Les parois magnétiques séparant les différents domaines magnétiques principaux (les domaines de fermeture sont de faible dimension et non représentés) se déplacent alors pour finalement ne laisser apparaître qu'un seul et unique domaine magnétique dont le moment magnétique présente la même orientation que le champ d'excitation H.

Dans le cas où le champ d'excitation H est appliqué selon un second axe privilégié du matériau magnétique (également appelé axe difficile), perpendiculaire à l'axe facile, comme illustré en figure 5, on assiste non pas à un déplacement des parois magnétiques mais à une rotation progressive des moments magnétiques des différents domaines magnétiques jusqu'à ce que tous les moments magnétiques présentent une seule et même orientation correspondant à celle du champ d'excitation H.

Lorsqu'il existe des déplacements et sauts de parois magnétiques (c'est-à-dire lorsque la composante du champ d'excitation H selon l'axe facile est non nulle), ces phénomènes donnent lieu à des pertes irréversibles par hystérésis dans les matériaux magnétiques (également appelé bruit de Barkhausen) et peuvent ainsi produire les instabilités des micro-fluxgates. Au cours de leur déplacement, les parois magnétiques auront à franchir certaines barrières de potentiel causées par les défauts du cristal (impuretés, contraintes, dislocations, joints de grain). Le déplacement des parois est donc saccadé, irréversible et dispersif et se fait par saut en se déplaçant d'un défaut dans le matériau à un autre constituant autant de points d'ancrage pour les parois magnétiques. C'est ce déplacement des parois magnétiques qui est à l'origine du bruit de Barkhausen.

On comprend aisément ainsi l'origine du phénomène de pertes par hystérésis et des instabilités qui en découlent.

De telles instabilités n'apparaissent que lorsque la taille des domaines magnétiques n'est pas négligeable devant la dimension des noyaux magnétiques, ce qui est le cas des noyaux miniatures utilisés pour réaliser des capteurs miniatures de champ magnétique.

En effet, pour les noyaux de taille plus importante, ces instabilités n'existent pas. Les capteurs « macro-fluxgates » peuvent par conséquent mesurer des champs magnétiques mille fois plus faibles, de l'ordre du picoTesla, le bruit des domaines magnétiques étant moyenné et n'intervenant donc pas dans le signal de sortie.

Afin de limiter ces instabilités, les capteurs « micro-fluxgates » sont conçus de façon à ne privilégier que les phénomènes de rotation d'aimantation du noyau magnétique en appliquant le champ d'excitation H sur l'axe difficile et avec des multicouches magnétiques couplées qui minimisent ces instabilités.

Cependant, il subsiste toujours un bruit magnétique. En effet, à chaque alternance du champ d'excitation H, les parois magnétiques du matériau magnétique réapparaissent à l'état désaimanté de sorte qu'à chaque alternance du flux magnétique, même si celui-ci ne circule que par rotation de l'aimantation, les parois magnétiques disparaissent et réapparaissent alternativement et peuvent ainsi fort bien réapparaître en un lieu légèrement différent du précédent. Ce phénomène de déplacement des domaines magnétiques d'une alternance à l'autre peut ainsi être assimilé de façon équivalente à un déplacement de paroi magnétique comme dans le cas où le champ est appliqué selon l'axe facile.

De plus, ce phénomène est amplifié dans le cas particulier du micro-fluxgate puisque le noyau magnétique d'un tel appareil présente de fortes variations de sa configuration en domaines magnétiques car il doit obligatoirement présenter des domaines magnétiques qui se saturent alternativement positivement et négativement à la fréquence du champ d'excitation. Les portions du noyau magnétique passent donc alternativement d'un état saturé positif à un état saturé négatif en traversant à chaque altemance un état d'équilibre où les parois magnétiques réapparaissent pour délimiter des domaines magnétiques et sont alors susceptibles d'engendrer, comme on l'a vu ci-dessus, un bruit magnétique parasite aléatoire lié à la non reproductibilité de leur positionnement.

On connaît déjà notamment par le brevet français 2 851 661 des capteurs miniatures de champ magnétique pour lesquels la forme du noyau magnétique a été conçue dans le but de réduire le bruit magnétique.

On connaît également par le brevet français 2 817 622 des capteurs miniatures de champ magnétique dans lequel le noyau magnétique est tronçonné arbitrairement pour limiter le déplacement des parois magnétiques à la dimension des portions tronçonnées.

L'invention a pour objet un capteur miniature du même type mais visant à minimiser encore davantage ce bruit magnétique.

Elle propose à cet effet capteur conforme à la revendication 1.

Les discontinuités, par exemple géométriques ou structurelles, réalisées dans le noyau constituent ainsi, à l'état désaimanté, autant de zones d'ancrage macroscopiques et reproductibles des parois magnétiques pour empêcher celles-ci d'occuper des zones d'ancrage microscopiques non contrôlables et aléatoires que constituent les défauts naturels du matériau. A chaque alternance du flux, lors du retour à l'état désaimanté, les parois magnétiques lorsqu'elles réapparaissent se placent naturellement et de façon systématique au niveau des discontinuités du noyau magnétique.

La disposition des discontinuités en fonction de l'emplacement probable des parois magnétiques assure une chance maximale de voir les parois magnétiques se fixer au niveau des discontinuités ainsi formées puisque c'est sensiblement à ces endroits qu'elles seraient apparues en l'absence de ces discontinuités.

La disposition de ces discontinuités minimise ainsi le déplacement aléatoire des parois magnétiques d'une alternance du flux à l'autre et donc également le bruit qui en est la conséquence. La réduction de ce bruit permet d'augmenter significativement la résolution des capteurs utilisant de tels noyaux et de détecter des champs magnétiques beaucoup plus faibles.

Selon des caractéristiques préférées, pour des raisons de simplicité, de commodité et d'économie de mise en oeuvre, éventuellement combinées :
- certaines au moins desdites discontinuités sont des restrictions totales de section dudit barreau ; et éventuellement
- lesdites restrictions forment des entrefers ; ou
- certaines au moins desdites discontinuités sont des restrictions partielles de section dudit barreau ; et éventuellement
- lesdites restrictions partielles sont des restrictions locales d'épaisseur dudit barreau ; et éventuellement
- lesdites restrictions s'étendent selon la direction transversale dudit barreau ; ou
- lesdites restrictions s'étendent selon la direction longitudinale dudit barreau ; et/ou
- lesdites restrictions forment des rainures ménagées dans ledit barreau ; et/ou
- lesdites restrictions sont des restrictions locales de la largeur dudit barreau ; ou
- lesdites restrictions sont des restrictions locales de la longueur dudit barreau ; et/ou
- lesdites restrictions forment chacune au moins une encoche au bord dudit barreau ; ou
- lesdites restrictions forment chacune deux encoches en regard l'une de l'autre et de part et d'autre dudit barreau ; ou
- certaines au moins desdites discontinuités sont des inhomogénéités de structure dudit barreau ; et événtuellement
- lesdites inhomogénéités sont en surface dudit barreau ; ou
- lesdites inhomogéhéités sont dans le volume dudit barreau et/ou
- lesdites inhomogénéités sont des inclusions de matière ; et/ou
- ledit noyau comporte un second barreau semblable audit premier barreau; et éventuellement
- lesdits barreaux sont reliés l'un à l'autre à leurs extrémités par des tronçons en matériau magnétique et forment un circuit magnétique fermé ; et/ou
- ledit noyau est formé d'un empilement de couches successives ; et éventuellement
- au moins certaines couches successives sont couplées magnétiquement.

L'invention vise égàlement un procédé de fabrication dudit noyau magnétique, caractérisé en ce qu'il comporte :
- l'étape d'identifier l'emplacement probable des parois magnétiques séparant les domaines magnétiques dudit noyau magnétique à fabriquer ;
- l'étape de déposer au moins une couche mince de matériau magnétique sur un support pour former ledit noyau magnétique ; et
- l'étape de réaliser dans ledit noyau des discontinuités sensiblement aux emplacements identifiés desdites parois magnétiques.

Selon des caractéristiques préférées, pour des raisons de simplicité et de commodité tant à la fabrication qu'à l'utilisation, éventuellement combinées :
- l'étape d'identification comporte l'étape consistant à prévoir au moins approximativement, en fonction des caractéristiques dudit noyau magnétique à fabriquer, la position desdits emplacements ; ou
- l'étape d'identification comporte une étape consistant à observer par micro-effet Kerr lesdits emplacements au sein d'un noyau magnétique dépourvu de discontinuités et de mêmes caractéristiques que ledit noyau magnétique à fabriquer ; et/ou
- ladite étape de réalisation de certaines au moins des discontinuités est mise en oeuvre par formation de restrictions sur ladite couche mince ; ou
- ladite étape de réalisation de certaines au moins des discontinuités est mise en oeuvre par formation d'inhomogénéités dans ladite couche mince.

L'exposé de l'invention sera maintenant poursuivi par la description d'un exemple de réalisation, donné ci-après à titre illustratif mais non limitatif, à l'appui des dessins annexés. Sur ces dessins :
- la figure 1 est un schéma d'un capteur de champ magnétique réalisé selon les techniques de l'art antérieur ;
- la figure 2 est un schéma d'un capteur de champ magnétique comportant un noyau magnétique conforme à l'invention ;
- la figure 3 est un schéma illustrant un exemple de répartition des domaines magnétiques principaux et des domaines de fermeture au sein d'un matériau magnétique ;
- les figures 4 et 5 sont deux schémas illustrant respectivement comment évoluent les moments magnétiques au sein du matériau magnétique lorsque le champ magnétique d'excitation est appliqué suivant l'axe facile du matériau et lorsque ce champ magnétique est appliqué suivant l'axe difficile ;
- les figures 6A et 6B sont deux vues de dessus schématiques illustrant les discontinuités, les parois magnétiques et les domaines magnétiques d'un tronçon d'un des barreaux que comporte un premier mode de réalisation du noyau selon l'invention ;
- les figures 7A et 7B sont deux vues similaires aux figures 6A et 6B mais pour un deuxième mode de réalisation du noyau selon l'invention ;
- les figures 8A et 8B sont deux vues similaires aux figures 6A et 6B mais pour un troisième mode de réalisation du noyau selon l'invention ;
- les figures 9A et 9B sont deux vues similaires aux figures 6A et 6B mais pour un quatrième mode de réalisation du noyau selon l'invention ;
- les figures 10A et 10B sont deux vues similaires aux figures 6A et 6B mais pour un cinquième mode de réalisation du noyau selon l'invention ; et
- les figures 11 à 15 sont des schémas représentant cinq étapes successives de fabrication d'un capteur conforme à l'invention.

Le capteur 10 représenté en figure 2 comporte un noyau magnétique fermé 11 coopérant avec des bobinages d'excitation 13 et un bobinage de détection 14, ce capteur comporte des pistes 16 en contact avec certaines des spires des bobinages délimitant ainsi les bobinages 13 et 14.

Le noyau magnétique est en matériau magnétique doux déposé en couche mince (notamment: permalloy, matériau amorphe ou autre) et comporte deux barreaux parallèles identiques 12 reliés l'un à l'autre à leurs extrémités par deux tronçons en demi-cercle 17.

Dans l'exemple illustré le noyau magnétique 11 présente une longueur de 1,4 mm et une largeur de 0.4 mm tandis que chaque barreau 12 présente une longueur de 1 mm et une largeur de 0.1 mm (100 microns).

Chaque barreau magnétique 12 (dont un tronçon est représenté en figures 6A et 6B) est constitué d'une pluralité de portions magnétiques disjointes 20 séparées entre elles par des entrefers 21. Les dimensions des portions magnétiques 20 ont été déterminées préalablement en identifiant l'emplacement des domaines magnétiques 6, soit par prévision de la taille naturelle des domaines magnétiques en fonction de la nature, des dimensions et de la structure des barreaux 12, soit en visualisant ces domaines magnétiques par exemple par micro-effet Kerr. Les portions magnétiques 20 présentent ainsi des dimensions égales ou très légèrement inférieures à celle des domaines magnétiques 6 des barreaux 12 afin que les portions magnétiques 20 soient monodomaines (elles ne présentent qu'un unique domaine magnétique 6, empêchant ainsi tout déplacement des parois magnétiques 8 à chaque alternance du flux au sein des barreaux 12).

A l'état désaimanté, comme illustré en figure 6B, les moments magnétiques de deux portions magnétiques adjacentes 20 sont de sens opposés (les domaines de fermeture sont de faible dimension et non représentés sur les figures) et les parois magnétiques 8 coïncident avec les entrefers 21. Après l'alternance suivante du flux, les sens des moments magnétiques au sein des portions magnétiques 20 s'inversent par rapport à ceux représentés en figure 6B mais les parois magnétiques 8 coïncident toujours avec les entrefers 21.

Le positionnement des parois magnétiques est ainsi contrôlé et reproductible pour chaque alternance du flux magnétique.

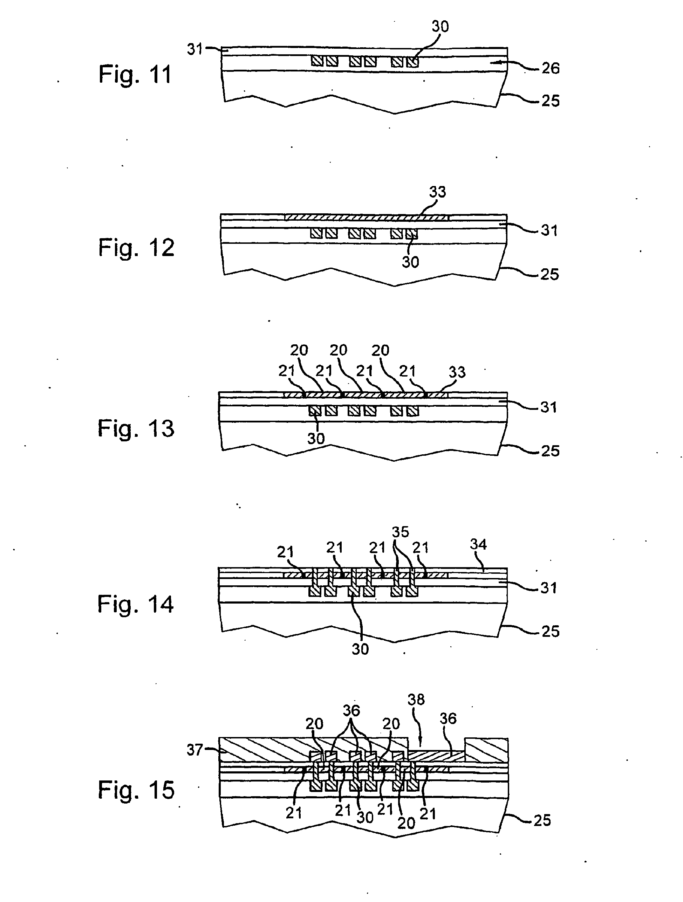

On va maintenant décrire le processus de fabrication d'un capteur conforme à l'invention à l'aide des figures 11 à 15.

Il s'agit d'étapes à peine modifiées par rapport à celles qui peuvent être utilisées pour certains capteurs magnétiques déjà réalisés en microtechnologie mais avec des noyaux magnétiques présentant des barreaux conventionnels.

Selon la figure 11, on part d'un substrat 25, par exemple en silicium (mais il peut s'agir en variante notamment de verre, de quartz ou de céramique), sur lequel on va réaliser une couche 26 en matériau électriquement isolant (par exemple en SiO₂) formant un « caisson de bobinage ». On dépose ensuite par électrolyse ou par pulvérisation cathodique des pistes 30 d'un matériau conducteur tel que le cuivre, l'aluminium, l'or, le tungstène, Ta/Au (une couche de tantale surmontée d'une couche d'or) puis on procède à une planarisation de ce matériau. On dépose enfin une couche d'isolant 31 (typiquement du SiO₂ avec une épaisseur de quatre microns dans l'exemple illustré), avant de lui appliquer un traitement de planarisation (en laissant jusqu'à moins d'un micron d'isolant 31 sur le matériau conducteur).

On procède ensuite (figure 12) à un dépôt de matériau magnétique 33, par exemple du FeNi, sur une épaisseur de l'ordre d'un micron.

On effectue ensuite une gravure de ce dépôt magnétique pour en définir la géométrie. On réalise également la succession de discontinuités, des entrefers 21 de quelques microns de largeur dans l'exemple illustré, sur le dépôt magnétique pour délimiter les portions magnétiques 20 (figure 13).

Pour cela on réalise par photolithographie un dépôt localisé du matériau magnétique en forme d'un motif avec entrefer, ou l'on grave, éventuellement partiellement, des entrefers sur la couche mince magnétique continue.

On recouvre ensuite le dépôt magnétique d'une nouvelle couche d'isolant 34 (figure 14), typiquement en SiO₂ que l'on planarise en laissant de l'ordre d'un micron d'isolant sur le matériau magnétique. La couche de matériau magnétique est ainsi localisée entre une couche isolante 31 et une couche isolante 34 et est entourée d'isolant (en pratique celui déposé lors de son recouvrement par la couche 34).

On procède ensuite, comme illustré en figure 14, aux opérations de réalisation des raccords 35 aux brins inférieurs en sorte de commencer à former les futures spires. La réalisation de ces raccords peut se faire par gravure localisée afin de creuser des tranchées jusqu'aux brins 30, puis dépôt et planarisation d'un matériau conducteur dans ces tranchées.

On procède enfin, comme illustré en figure 15, à un dépôt 36 d'un matériau conducteur d'épaisseur égale à 1,5 micron. On effectue ensuite une gravure en sorte de délimiter dans cette couche conductrice des conducteurs supérieurs, formant ainsi des spires conjointement avec les brins 30 et les raccords 35. On procède enfin à un dépôt d'isolant 37 en SiO₂, puis on réalise des ouvertures 38 pour réaliser les contacts électriques avec les pistes 16 du capteur.

On va maintenant décrire quatre autres modes de réalisation des barreaux magnétiques d'un noyau conforme à l'invention.

Pour chaque mode de réalisation supplémentaire, on a conservé pour des éléments similaires les mêmes références numériques que pour le mode de réalisation précédant augmentées du chiffre 100.

Dans un mode de réalisation représenté en figures 7A et 7B, chaque barreau magnétique 112 du noyau magnétique 111 est réalisé d'une seule pièce et présente à intervalle régulier des discontinuités permanentes partielles, ici des rainures transversales 121, s'étendant sur toute la largeur du barreau et réduisant localement son épaisseur en délimitant les différentes portions magnétiques 120. Ces rainures 121 sont disposées de sorte que les portions magnétiques 120 ne présentent qu'un unique domaine magnétique 106.

Ainsi lors du passage à l'état désaimanté les rainures 121 forment des lignes d'ancrage sur lesquelles se fixent naturellement et de façon reproductible à chaque alternance du flux les parois magnétiques 108 du barreau 112.

A l'état désaimanté représenté en figure 7B, les parois magnétiques 108 se confondent avec les rainures 121 tandis que les domaines magnétiques 106 coïncident avec les portions magnétiques 120.

Ces rainures sont réalisées de façon similaire à la réalisation des entrefers, soit par photolithographie soit par abrasion laser par exemple. Une autre solution consiste à déposer le matériau magnétique sur des plots réalisés au préalable sous la couche mince.

Dans un autre mode de réalisation non représenté, les rainures sont remplacées par tout autre type de discontinuités permanentes partielles telles que par exemple des inhomogénéités de structure permettant d'obtenir une discontinuité entre deux domaines magnétiques adjacents soit en surface soit dans le volume du barreau afin de former les zones d'ancrage des parois magnétiques sans pour autant entraîner un morcellement du barreau.

On entend ainsi ici par discontinuités permanentes partielles notamment aussi bien les restrictions partielles de section du barreau que les inhomogénéités de structure de ce barreau.

Pour réaliser ces inhomogénéités, une solution consiste à modifier localement la structure de la matière en réalisant un « recuit localisé » par exemple à l'aide d'un laser ou encore à réaliser des inclusions en déposant un autre matériau avant, pendant ou après le dépôt du matériau magnétique par photolithographie ou par implantation ionique par exemple.

Dans encore un autre mode de réalisation représenté en figure 8A et 8B, chaque barreau magnétique 212 du noyau magnétique 211 est d'une seule pièce et présente de part et d'autre de la direction longitudinale du barreau des encoches 221 taillées à intervalle régulier dans l'épaisseur du barreau en réduisant localement sa largeur.

Les parois magnétiques 208 se placent ainsi naturellement entre les pointes de deux encoches 221 situées en regard l'une de l'autre, les portions magnétiques 220 ne présentant qu'un unique domaine magnétique 206.

Ces encoches sont réalisées en étant prédéfinies dans les masques permettant d'obtenir la forme générale de la couche mince magnétique.

Il est également possible d'appliquer ces méthodes (rayures, inclusions, encoches) à toutes sortes de motifs sur le barreau, en fonction des emplacements qu'occupent les domaines magnétiques tels que ceux représentés en figure 9B, l'emplacement et la forme générale des domaines magnétiques dépend notamment de l'anisotropie du matériau magnétique, de sa nature, de sa structure et de ses dimensions..

Dans un autre mode de réalisation représenté en figure 10A et 10B, dans le cas où les parois magnétiques sont orientées selon la direction longitudinale du barreau (axe difficile) du fait par exemple de l'anisotropie de forme ou de l'anisotropie du matériau magnétique, le barreau 412 présente alors une ou plusieurs rayures 421 s'étendant sur toute la longueur du barreau 412 en réduisant localement son épaisseur. Une alternative consiste à réaliser à la place de la rayure 421 une ou plusieurs encoches dans les petits cotés du barreau pour réduire localement la longueur de celui-ci afin que les parois magnétiques 408 se fixent naturellement à l'état désaimanté entre les pointes de ces encoches.

Dans d'autres modes de réalisation non représentés, le noyau magnétique présente deux barreaux magnétiques disjoints formant à eux deux un circuit magnétique ouvert.

Le noyau peut être constitué non pas d'une seule couche mince magnétique mais de plusieurs couches minces magnétiques séparées par des couches minces isolantes (multicouches), les couches magnétiques pouvant ou non être magnétiquement couplées.

Dans encore d'autres modes de réalisation non représentés le capteur comporte un bobinage supplémentaire pour appliquer un champ compensant le champ magnétique continu ou basse fréquence à mesurer et/ou une bobine de stabilisation déposée à proximité du micro-fluxgate pour participer à la réduction du bruit et des instabilités du signal de sortie.

Dans encore d'autres modes de réalisation les bobinages peuvent être solénoïdaux ou en spirale planaire et/ou être entrelacés.

Dans encore d'autres modes de réalisation les discontinuités (les rainures par exemple) sont réalisées de façon interrompue d'un bord à l'autre des barreaux et/ou ces discontinuités sont réalisées non par sur une seule mais sur chacune des faces principales des barreaux.

Dans d'autres modes de réalisation, les différents types de discontinuités (restrictions totales de section, restrictions partielles de section, inhomogénéités de structure, etc.) peuvent coexister au sein d'un même noyau magnétique voire au sein d'un même barreau ou tronçon de barreau.

Dans encore d'autres modes de réalisation le noyau magnétique est utilisé pour réaliser des composants autres que des capteurs miniatures de champ magnétique.

Dans ce qui précède et pour tous les modes de réalisation exposés ci-dessus, que ce soit lorsque les discontinuités sont des restrictions totales ou partielles de section, dans une direction ou dans l'autre du barreau, sur une ou deux faces ou bien encore dans le cas d'inhomogénéités de structure, la détermination probable des parois magnétiques permet de répartir de façon optimale les discontinuités sur le barreau.

Selon un autre aspect de l'invention, original en soi, celle-ci concerne aussi de manière très générale un noyau magnétique miniature présentant, à l'état désaimanté, une pluralité de domaines magnétiques séparés par des parois magnétiques, caractérisé en ce qu'au moins un tronçon de barreau présente des discontinuités permanentes partielles destinées à fixer la position d'au moins certaines des parois magnétiques (sans nécessairement les déterminer à l'avance).

## Revendications

1. Capteur miniature de champ magnétique, comportant un noyau miniature (11 ; 111 ; 211 ; 311 ; 411) coopérant avec au moins un bobinage d'excitation (13) et un bobinage de détection (14), le noyau magnétique miniature comportant au moins un barreau magnétique (12 ; 112 ; 212 ; 312 ; 412) présentant, à l'état désaimanté, une pluralité de domaines magnétiques (6 ; 106 ; 206 ; 306 ; 406) séparés par des parois magnétiques (8 ; 108 ; 208 ; 308; 408), **caractérisé en ce que** ledit barreau (12 ; 112 ; 212 ; 312 ; 412) présente des discontinuités permanentes (21 ; 121 ; 221 ; 321 ; 421) disposées au moins approximativement aux emplacements probables d'au moins certaines de ces parois magnétiques (8 ; 108 ; 208 ; 308 ; 408) en l'absence de ces discontinuités permanentes (21 ; 121 ; 221 ; 321 ; 421).

2. Capteur selon la revendication 1, **caractérisé en ce que** certaines au moins desdites discontinuités (21) sont des restrictions totales de section dudit barreau (12).

3. Capteur selon la revendication 2, **caractérisé en ce que** lesdites restrictions forment des entrefers (21).

4. Capteur selon la revendication 1, **caractérisé en ce que** certaines au moins desdites discontinuités sont des restrictions partielles (121 ; 221 ; 321 ; 421) de section dudit barreau (112 ; 212 ; 312 ; 412).

5. Capteur selon la revendication 4, **caractérisé en ce que** lesdites restrictions forment des rainures (121 ; 321 ; 421) ménagées dans ledit barreau (112, 312; 412).

6. Capteur selon la revendication 4, **caractérisé en ce que** lesdites restrictions forment chacune au moins une encoche (221) au bord dudit barreau (212).

7. Capteur selon la revendication 6, **caractérisé en ce que** lesdites restrictions forment chacune deux encoches (221) en regard l'une de l'autre et de part et d'autre dudit barreau (212).

8. Capteur selon la revendication 1, **caractérisé en ce que** certaines au moins desdites discontinuités sont des inhomogénéités de structure dudit barreau.

9. Capteur selon l'une quelconque des revendications 1 à 8, **caractérisé en ce que** le noyau comporte un second barreau (12 ; 112 ; 212 ; 312 ; 412) semblable audit premier barreau (12 ; 112 ; 212 ; 312 ; 412).

10. Capteur selon la revendication 9, **caractérisé en ce que** lesdits barreaux (12 ; 112 ; 212 ; 312 ; 412) sont reliés l'un à l'autre à leurs extrémités par des tronçons en matériau magnétique (17) et forment un circuit magnétique fermé.

11. Capteur selon l'une quelconque des revendications 1 à 10, **caractérisé en ce que** le noyau est formé d'un empilement de couches successives (26, 30, 31, 33, 34, 35, 36, 37), au moins certaines couches successives (26, 30, 31, 33, 34, 35, 36, 37) étant couplées magnétiquement.

12. Procédé de fabrication d'un noyau magnétique pour un capteur selon l'une quelconque des revendications 1 à 11, **caractérisé en ce qu'**il comporte :
- l'étape d'identifier l'emplacement probable des parois magnétiques (8 ; 108 ; 208 ; 308 ; 408) séparant les domaines magnétiques (6 ; 106; 206; 306; 406) dudit noyau magnétique (11 ; 111 ; 211 ; 311 ; 411) à fabriquer ;
- l'étape de déposer au moins une couche mince (33) de matériau magnétique sur un support pour former ledit noyau magnétique (11 ; 111 ; 211 ; 311 ; 411); et
- l'étape de réaliser dans ledit noyau (11 ; 111 ; 211 ; 311 ; 411) des discontinuités (21 ; 121 ; 221 ; 321 ; 421) sensiblement aux emplacements identifiés desdites parois magnétiques (8 ; 108 ; 208 ; 308 ; 408).

13. Procédé selon la revendication 12, **caractérisé en ce que** l'étape d'identification comporte l'étape consistant à prévoir au moins approximativement, en fonction des caractéristiques dudit noyau magnétique à fabriquer (11 ; 111 ; 211 ; 311 ; 411), la position desdits emplacements.

14. Procédé selon la revendication 12, **caractérisé en ce que** l'étape d'identification comporte une étape consistant à observer par micro-effet Kerr lesdits emplacements au sein d'un noyau magnétique dépourvu de discontinuités et de mêmes caractéristiques que ledit noyau magnétique à fabriquer (11 ; 111 ; 211 ; 311 ; 411).

## Claims

1. Miniature magnetic field sensor comprising a miniature core (11 ; 111 ; 211 ; 311 ; 411) cooperating with at least one excitation coil (13) and one detection coil (14), the miniature magnetic core comprising at least one magnetic bar (12 ; 112 ; 212 ; 312 ; 412) having, in the de-magnetized state, a plurality of magnetic domains (6 ; 106 ; 206 ; 306 ; 406) separated by magnetic walls (8 ; 108 ; 208 ; 308 ; 408), **characterized in that** said bar (12 ; 112 ; 212 ; 312 ; 412) has permanent discontinuities (21 ; 121 ; 221 ; 321 ; 421) positioned at least approximately at the probable locations of at least certain of these magnetic walls (8 ; 108 ; 208 ; 308 ; 408) if these permanent discontinuities (21 ; 121 ; 221 ; 321 ; 421) were to be absent.

2. Sensor according to claim 1, **characterized in that** at least some of said discontinuities (21) are total restrictions of section of said bar (12).

3. Sensor according to claim 2, **characterized in that** said restrictions form air gaps (21).

4. Sensor according to claim 1, **characterized in that** at least some of said discontinuities are partial restrictions (121 ; 221 ; 321 ; 421) of section of said bar (112 ; 212 ; 312 ; 412).

5. Sensor according to claim 4, **characterized in that** said restrictions form grooves (121 ; 321 ; 421) made in said bar (112 ; 312 ; 412).

6. Sensor according to claim 4, **characterized in that** said restrictions each form at least one notch (221) on the edge of said bar (212).

7. Sensor according to claim 6, **characterized in that** said restrictions each form two notches (221) facing each other and placed on either side of said bar (212).

8. Sensor according to claim 1, **characterized in that** at least certain of said discontinuities are inhomogeneities of structure of said bar.

9. Sensor according to any one of the claims 1 to 8, **characterized in that** the core has a second bar (12 ; 112 ; 212 ; 312 ; 412) similar to said first bar (12; 112; 212; 312; 412).

10. Sensor according to claim 9, **characterized in that** said bars (12 ; 112 ; 212 ; 312 ; 412) are connected to one another at their ends by sections of magnetic material (17) and form a closed magnetic circuit.

11. Sensor according to any one of the claims 1 to 10 **characterized in that** the core is formed by a stack of successive layers (26, 30, 31, 33, 34, 35, 36, 37), at least certain successive layers (26, 30, 31, 33, 34, 35, 36, 37) being magnetically coupled.

12. Method for making a magnetic core for a sensor according to any one of the claims 1 to 11, **characterized in that** it comprises:
- the step of identifying the probable location of the magnetic walls (8 ; 108 ; 208 ; 308 ; 408) separating the magnetic domains (6 ; 106 ; 206 ; 306 ; 406) of said magnetic core (11 ; 111 ; 211 ; 311 ; 411) to be made ;
- the step of depositing at least one thin layer (33) of magnetic material on a base to form said magnetic core (11 ; 111 ; 211 ; 311 ; 411); and
- the step of making, in said core (11 ; 111 ; 211 ; 311 ; 411), discontinuities (21 ; 121 ; 221 ; 321 ; 421) substantially at the identified locations of said magnetic walls (8 ; 108 ; 208 ; 308 ; 408).

13. Method according to claim 12 **characterized in that** the identification step comprises the step consisting in predicting, at least approximately, the positions of said locations as a function of the characteristics of said magnetic core (11 ; 111 ; 211 ; 311 ; 411) to be made.

14. Method according to claim 12, **characterized in that** the identification step comprises a step consisting in observing, by micro-Kerr-effect, said locations within the magnetic core devoid of discontinuities and having the same characteristics as said magnetic core (11 ; 111 ; 211 ; 311 ; 411) to be made.

## Patentansprüche

1. Miniatursensor eines magnetischen Feldes mit einem Miniaturkern (11; 111; 211; 311; 411), der mit wenigstens einer Erregungswicklung (13) und einer Erfassungswicklung (14) zusammenwirkt, wobei der magnetische Miniaturkern wenigstens einen magnetischen Stab (12; 112; 212; 312; 412) umfasst, der im entmagnetisierten Zustand eine Vielzahl von magnetischen Bereichen (6; 106; 206; 306; 406) aufweist, die durch magnetische Wände (8; 108; 208; 308; 408) voneinander getrennt sind, **dadurch gekennzeichnet, dass** der genannte Stab (12; 112; 212; 312; 412) permanente Unterbrechungen (21; 121; 221; 321; 421) aufweist, die bei Fehlen dieser permanenten Unterbrechungen (21; 121; 221; 321; 421) wenigstens ungefähr an den vermutlichen Stellen wenigstens einiger dieser magnetischen Wände (8; 108; 208; 308; 408) angeordnet sind.

2. Sensor gemäß Anspruch 1, **dadurch gekennzeichnet, dass** wenigstens einige der genannten Unterbrechungen (21) totale Querschnittsbegrenzungen des genannten Stabes sind.

3. Sensor gemäß Anspruch 2, **dadurch gekennzeichnet, dass** die genannten Begrenzungen Luftspalte (21) bilden.

4. Sensor gemäß Anspruch 1, **dadurch gekennzeichnet, dass** wenigstens bestimmte der genannten Unterbrechungen teilweise Querschnittsbegrenzungen (121; 221; 321; 421) des genannten Stabes (112; 212; 312; 412) sind.

5. Sensor gemäß Anspruch 4, **dadurch gekennzeichnet, dass** die genannten Begrenzungen Rillen (121; 321; 421) bilden, die in dem genannten Stab (112; 312; 412) angeordnet sind.

6. Sensor gemäß Anspruch 4, **dadurch gekennzeichnet, dass** die genannten Begrenzungen jeweils wenigstens eine Einkerbung (221) am Rand des genannten Stabes (212) bilden.

7. Sensor gemäß Anspruch 6, **dadurch gekennzeichnet, dass** die genannten Begrenzungen jeweils zwei einander gegenüber und auf jeder Seite des genannten Stabes (221) liegende Einkerbungen (221) bilden.

8. Sensor gemäß Anspruch 1, **dadurch gekennzeichnet, dass** wenigstens bestimmte der genannten Unterbrechungen Strukturunregelmäßigkeiten des genannten Stabes sind.

9. Sensor gemäß Anspruch 1 bis 8, **dadurch gekennzeichnet, dass** der Kern einen zweiten Stab (12; 112; 212; 312; 412) umfasst, der ähnlich dem genannten ersten Stab (12; 112; 212; 312; 412) ist.

10. Sensor gemäß Anspruch 9, **dadurch gekennzeichnet, dass** die genannten Stäbe (12; 112; 212; 312; 412) an ihren Enden durch Abschnitte aus magnetischem Material (17) untereinander verbunden sind und einen geschlossenen magnetischen Schaltkreis bilden.

11. Sensor gemäß Anspruch 1 bis 10, **dadurch gekennzeichnet, dass** der Kern durch eine Stapelung von sukzessiven Schichten (26, 30, 31, 33, 34, 35, 36, 37) gebildet ist, wobei wenigstens bestimmte sukzessive Schichten (26, 30, 31, 33, 34, 35, 36, 37) magnetisch miteinander gekoppelt sind.

12. Herstellungsverfahren eines magnetischen Kerns für einen Sensor gemäß Anspruch 1 bis 11, **dadurch gekennzeichnet, dass** es umfasst:
- Die Stufe zur Identifikation der vermutlichen Stelle der magnetischen Wände (8; 108; 208; 308; 408), die die magnetischen Bereiche (6; 106; 206; 306; 406) vom genannten, herzustellenden Kern (11; 111; 211; 311; 411) trennen;
- Die Stufe des Aufbringens von wenigstens einer dünnen Schicht (33) aus magnetischem Material auf einem Träger, m den genannten magnetischen Kern (11; 111; 211; 311; 411) zu bilden; und
- Die Stufe der Realisierung der Unterbrechungen (21; 121; 221; 321; 421) in dem genannten Kern (11; 111; 211; 311; 411) deutlich an den identifizierten Stellen der genannten magnetischen Wände (8; 108; 208; 308; 408).

13. Verfahren gemäß Anspruch 12, **dadurch gekennzeichnet, dass** die Identifizierungsstufe die Stufe umfasst, die darin besteht, wenigstens ungefähr in Abhängigkeit von den Merkmalen des genannten herzustellenden magnetischen Kerns (11; 111; 211; 311; 411), die Position der genannten Stellen vorzusehen.

14. Verfahren gemäß Anspruch 12, **dadurch gekennzeichnet, dass** die Identifizierungsstufe eine Stufe umfasst, die in der Beobachtung der genannten Stellen innerhalb eines magnetischen Kerns ohne Unterbrechungen und mit denselben Merkmalen wie der genannte herzustellende magnetische Kern (11; 111; 211; 311; 411) per Mikro-Kerreffekt besteht.
